# EUROPEAN PATENT APPLICATION

(11) **EP 1 289 180 A1**
(43) Date of publication of application: **05.03.2003**
(21) Application number: 01925930.8
(22) Date of filing: 25.04.2001
(51) Int. Cl.: H04L 1/00, H03M 13/45

(54) **DATA DECODING METHOD**

(71) Applicant: MITSUBISHI DENKI KABUSHIKI KAISHA, Tokyo 100-8310 (JP)
(72) Inventor: UGA, Shinsuke, MITSUBISHI DENKI KABUSHIKI KAISHA, Tokyo 100-8310 (JP)
(74) Representative: Bohnenberger, Johannes, Dr.
(86) International application number: JP0103594
(87) International publication number: WO02091656

(57) **Abstract**

Where the number of bits of data that can be transmitted within 1 frame is limited and repetitive bit information exists for certain information within 1 frame, information having maximum reliability is selected as the bit information therefrom, or one having maximum amplitude value among the same bit symbols is selected as bit information for decoding. When there is bit information not transmitted with respect to certain information in 1 frame, reliability information having 0 reliability is used for decoding process.

## Description

### Technical Field

The present invention relates to a data decoding method. More specifically, the present invention relates to a data decoding method for decoding data with limited bit number, based on a Reed-Muller coded TFCI (Transport Format Combination Indicator) transferred in association with the transmitted data, in a communication system defined by 3rd Generation Partnership Project (3GPP).

### Background Art

In the 3GPP defined communication system, communication of various services is made possible to meet various demands in communications, and specification that can support a transmission rate of up to 2Mbps is defined.

The services include continuous data such as voice and moving pictures, as well as high speed packets, and the system is characterized in that multiple services are multiplexed to be transported over one or multiple channels (physical channels) on a physical layer.

In the 3GPP defined communication system, in order to realize communication of various different types of data mentioned above, an agreement is made on Transport Format Combination Set (TFCS) for a layer 3 message. Which Transport Format Combination (TFC) in the set is to be used for transport is selected, dependent on the transport flow rate, by an MAC (Medium Access Control) layer which is a sub layer of the second layer on the transmitting side, and an indicator (Transport Format Combination Indicator-TFCI) indicating the combination of the transport formats is transferred in association with the transport data.

In the second layer, based on the selected transport format, error correction coding of the transport data itself and mapping to the physical channel are performed. On the receiving side, in order to perform format conversion from the physical channel to the channel for transport and error correction decoding, it is necessary to recognize the format based on the TFCI transmitted in association with the data, as means for recognizing which transport format combination (TFC) has been used for transport. Based on the TFCI, the aforementioned transport format combination set (TFCS) is referred to, the transfer format combination (TFC) is recognized, and format conversion from the physical channel to the channel (transport channel) for transport and error correction decoding are performed.

Here, communication refers to radio communication, and therefore, it is necessary to consider a case where transport environment is deteriorated. In 3GPP defined communication system, it is defined that error correction protection is performed on the actual transport data, using Turbo code with coding ratio of 1/3 or a convolutional code with the coding ratio of 1/2 or 1/3.

Further, it is defined that the TFCI transmitted in association with the data is also coded with (32, 10) sub-code of second order Reed-Muller code or (16, 5) bi-orthogonal code (first order Reed-Muller code). Compared with the Turbo code or convolutional code, the Reed-Muller code has lower correction capability.

However, the format conversion from the physical channel to the multiple transport channels and the following error correction decoding mentioned above are performed based on the result of TFCI error correction decoding. More specifically, when there is an error in TFCI detection, error correction decoding of the data itself becomes impossible. Thus, error characteristic of the TFCI becomes a bottleneck, determining the overall reception performance.

Here, the number of bits of TFCI that can be mapped in 1 radio frame is fixed in some radio frame formats, and in some cases it is 30 bits or 120 bits.

However, when the result of coding of TFCI consists of 32 bits, for example, it follows that the result is transferred in 30 bits or 120 bits in the radio frame format. Here, according to 3GPP specification, when transmission is to be performed with 30 bits, it is defined that 2 bits among the 32-bit coded TFCI are punctured for transmission. When transmission is to be performed with 120 bits, it is defined that 24 bits among 32 bits are subjected to bit repetition four times, and 8 bits are subjected to bit repetition three times for transmission.

Therefore, on the receiving side, 30 bits or 120 bits, for example, are received for one radio frame. It is necessary to perform depuncture processing, that corresponds to the bit puncture processing effected on the transmitting side, on the received data, or to perform bit derepetition process corresponding to the repetition process effected on the transmitting side, so as to form data that corresponds to the encoded 32 bits and to perform decoding process.

Conventionally, a random value is added corresponding to the non-existent symbol (the symbol that has been subjected to bit puncture) on the receiving side, and the data is decoded. There is a problem, however, that data reliability degrades because of the random value.

When the bit number of data is limited to 120 bits and the number of bits to be transmitted is small, the bit information included in the data is repeated to increase the bit number for transmission, and on the receiving side, bit information of the head symbol is selected among the repeated symbols, for decoding. It is not the case, however, that the head symbol always has high reliability.

### Disclosure of the Invention

Therefore, an object of the present invention is to provide a data decoding method that is capable of data decoding with higher reliability, when the number of data bits to be transmitted is limited.

The present invention provides a data decoding method including the steps of: receiving data that has been subjected to bit repetition process, based on the number of data bits that can be transmitted within 1 frame; deciding, based on reliability information of each repeated bit of the data, corresponding bit information; and decoding said data based on the determined bit information.

More preferably, in the step of decision, a bit having maximum reliability is selected from the repeated bits, and the selected bit is determined to be the bit information.

More preferably, in the step of decision, bit information is decided based on the added value of reliability of each of the repeated bits.

More preferably, in the step of decision, added mean value of reliability of each of the repeated bits is calculated, and the added mean value is determined to be the bit information.

According to another aspect, the method includes the steps of: receiving data that has been subjected to bit puncture processing based on the number of data bits that can be transferred within one frame; and decoding the data using reliability information of the punctured bit of the data as a low set value.

More preferably, in the step of decoding, a bit of which reliability is 0 is inserted to the data.

### Brief Description of the Drawings

Fig. 1 is a block diagram representing an overall configuration of a W-CDMA radio communication terminal device in accordance with one embodiment of the present invention.
Fig. 2 shows a process flow of received data and TFCI, for controlling of receiving part transmission path coding unit shown in Fig. 1.
Fig. 3 is a flow chart representing data processing procedure in accordance with one embodiment of the present invention.

### Best Modes for Carrying out the Invention

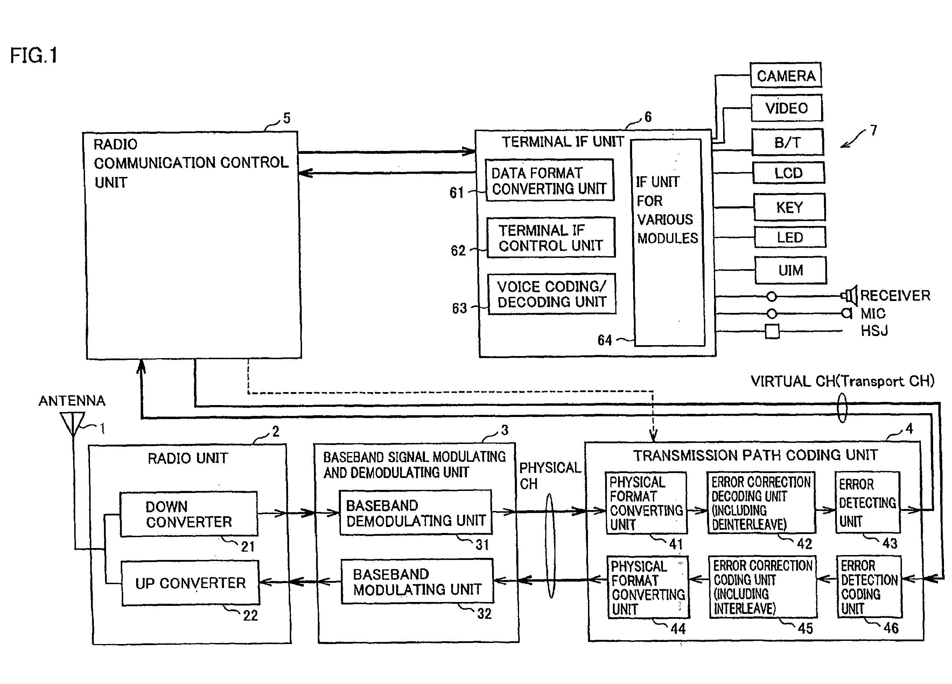

Fig. 1 is a block diagram representing an overall configuration of the W-CDMA radio communication terminal device in accordance with one embodiment of the present invention. Referring to Fig. 1, an antenna 1 is connected to a radio wave unit 2. Radio wave unit 2 includes a down converter 21 and an up converter 22. Down converter 21 converts a high frequency signal of a reception band to a baseband signal, and up converter 22 converts the baseband signal to a high frequency signal of a transmission band.

Baseband signal modulating and demodulating unit 3 includes baseband demodulating unit 31 and baseband modulating unit 32. Baseband demodulating unit 31 performs baseband demodulation on a signal that has been down converted and A/D converted at radio unit 2. In the CDMA system, despreading demodulation, rake combining and other operations are performed. Baseband modulating unit 32 performs baseband modulation on a signal that has been subjected to error correction coding and converted to a physical channel at transmission path coding unit 4. In the CDMA system, spreading modulation is performed.

Transmission path coding unit 4 includes physical format converting unit 44, an error correction coding unit 45 including interleaving and error detection coding unit 46 of transmitting part, as well as a physical format converting unit 41, error correction decoding unit 42 including deinterleaving, and error detecting unit 43 of receiving part.

Physical format converting unit 41 multiplexes and demultiplexes one or multiple received physical channels to one or multiple determined transport channels, error correction decoding unit 42 performs error correction decoding of a transport channel block, and error detecting unit 43 performs error detection of the corrected transport channel block. Error correction decoding unit 46 adds an error detection code to the block(s) of one or multiple transport channels transferred from an upper layer, error correction coding unit 45 performs error correction coding on the data to which the error detection code has been added, and the physical format converting unit 44 multiplexes multiple transport channels and maps to multiple physical channels.

Radio communication control unit 5 performs protocol control for radio communication, control of radio unit 2, baseband modulating and demodulating unit 3 and transmission path coding unit 4 therefor, and communicates with terminal IF unit 6. Terminal IF unit 6 has IF functions for user IF modules such as a camera and an LCD, and includes data format converting unit 61, terminal IF control unit 62, voice coding/decoding unit 63 and IF unit 64 for various modules.

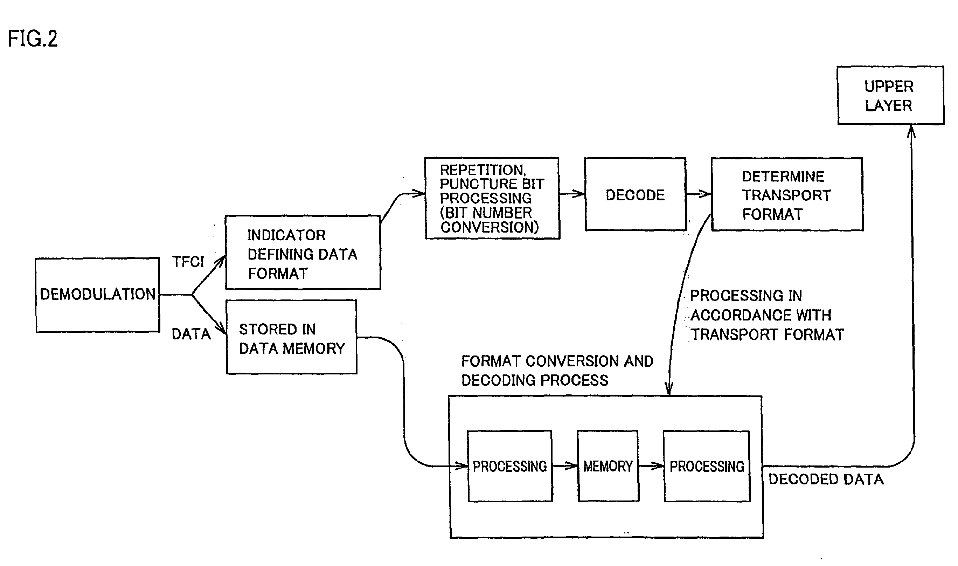

Fig. 2 shows a process flow of received data and TFCI, for controlling the receiving part of the transmission path coding unit in accordance with one embodiment of the present invention. The TFCI and the data that have been demodulated at baseband signal modulating and demodulating unit 3 are demultiplexed as shown in Fig. 2, and the data is temporarily stored in a memory. The TFCI transported over the physical channel has been subjected to bit repetition process or bit puncturing process, to be adapted to physical channel format. Such TFCI is subjected to reverse process of the repetition or puncturing, so that it is converted to the number of bits after the error correction coding.

Thereafter, error correction decoding process is performed, and a decoded TFCI is obtained. The transport format of each transport channel is determined based on the TFCI, and the data is processed based on the determined transport format.

In the TFCI determining process, as already described, the bit derepetition process for the bits repeated on the transmitting side or bit depuncture process for the bits punctured on the transmitting side is performed for error correction decoding. The process operation will be described in the following.

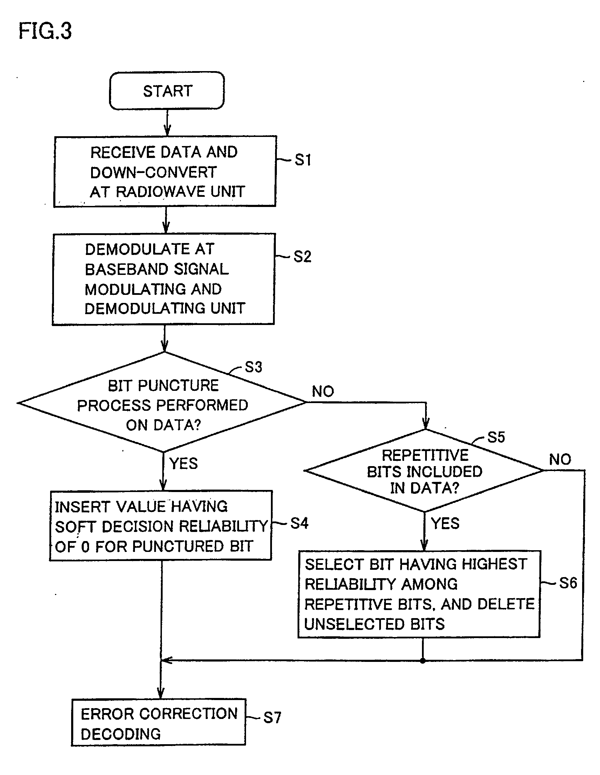

Fig. 3 is a flow chart representing an operation of one embodiment of the present invention. Referring to Fig. 3, in step (simply denoted by S in the figure) S1, radiowave unit 2 receives and down-converts data, and in step S2, the data is subjected to demodulation processing at baseband signal modulating and demodulating unit 3. Transmission path coding unit 4 determines whether data has been subjected to puncture processing or not in step S3. When bit puncture processing has been performed, in step S4, a value of which soft decision reliability is 0 is inserted for the punctured bit.

More specifically, when bit puncture processing has been performed on the transmitting side, for example, when coded TFCI consists of 32 bits (a0, a1, a2, ... a31) and the number of TFCI transmission bits is 30 bits in the radio frame format, 2 bits, that is, a30 and 31 are punctured, and a0, a1, a2, ... a29 are transmitted. At this time, on the receiving side, a'0, a'1, a'2, ... a'29 that correspond to the transmitted a0, a1, a2, ... a29 are received. In order to perform soft decision decoding process from a'0, a'1, a'2, ... a'29, it is necessary to generate a'30 and a'31.

Here, a value of which soft decision reliability is 0 is inserted for a'30 and a'31 to be generated. This is the procedure taken in order to have error correction logic determine the value as insignificant symbols, as dummy symbol values are generated from the data that has not actually been transmitted. Therefore, in step S7, the received data can be decoded with highest possible accuracy.

When it is determined in step S3 mentioned above that bit puncture processing is not performed and when it is determined in step S5 that the data includes repeated bits, the following process is performed in step S6. When bit repetition process is performed on the transmitting side, for example, when coded TFCI consists of 32 bits (a0, a1, a2,... a31) and the TFCI transmission bit number is 43 bits in the radio frame format in addition to 32 bits consisting of a0, a1, a2, ... a31, 11 bits consisting of a0, a1, a2, ..., a10 are transmitted repeatedly.

On the receiving side, a'0, a'1, a'2, ... a'31 and a"0, a"1, a"2, ... a"10 are received, which correspond to transmitted a0, a1, a2, ... a31 and bit-repeated a0, a1, a2, ... a10. Here, in order to perform derepetition process for the repetition process performed on the transmitting side, one of a'0 and a"0 which has higher reliability is selected as the data of the 0th bit.

Similarly, for the repeated bits, that is the data from the 1st to 11th bits, one having higher reliability is selected from repeatedly received data a'1, a'2, a'3, ..., a"1, a"2, a"3, ..., a"10, respectively, and unselected bits are deleted.

Through the above described process, data of 32 bits is formed and error correction decoding process is performed in step S7. Thus, the received data can be decoded with highest possible accuracy. As the TFCI is determined based on the result of decoding, accuracy of TFCI can effectively be improved.

Details of an example for setting reliability will be described in the following. It is assumed that digital data is transmitted with phase modulation, with data 0 being +1 and 1 being - 1, and that on the receiving side, demodulated data symbol is transferred to the transmission path coding unit as soft decision symbol of 8 bits. Further, it is assumed that the soft decision data is represented in 2's complement. Namely, data representation of 1 symbol satisfies the following relation. 0 higher reliability 0 lower reliability 1 lower reliability 1 higher reliability 7f (hex) ←01 (hex) ←00 (hex) FF (hex) → 80 (hex)

Therefore, when bit puncture processing has been performed, 00 comes to have the reliability of 0, and hence, a30=00, and a31=00.

Assume that-the bit repetition processing has been performed and a'0 is 4E (hex) and a"0 is 10 (hex), for example. When one having higher reliability is to be selected, a0=4E is selected, as 4E (hex) > 10 (hex). When determination is made based on the added value, 4E+10=5E, and therefore, a0=5E is determined. When determination is made based on added mean value, a0=2F is determined.

As described above, according to the present invention, when the number of bits that can be transmitted within 1 frame is limited and repetitive bit information exist for certain information, one having maximum reliability information is selected as the bit information, or among same bit symbols, one having maximum amplitude value is selected as the bit information. Thus, data can be decoded with improved reliability.

### Industrial Applicability

The present invention enables data decoding with higher reliability when the number of data bits that can be transmitted within 1 frame is limited, and hence the present invention is applicable to a terminal device for radio communication such as a mobile handset.

## Claims

1. A data decoding method, comprising the steps of:
receiving data that has been subjected to bit repetition processing, based on number of data bits that can be transmitted within 1 frame;
determining, based on reliability information of each of the repeated bits of said data, corresponding bit information; and
decoding said data using said determined bit information.

2. The data decoding method according to claim 1, wherein
in said step of determining, a bit having highest reliability is selected among said repeated bits, and the selected bit is determined to be said bit information.

3. The data decoding method according to claim 1, wherein
in said step of determining, said bit information is determined based on added value of reliability of each of said repeated bits.

4. The data decoding method according to claim 1, wherein
in said step of determining, added mean value of reliability of each of said repeated bits is calculated, and the added mean value is determined to be said bit information.

5. A data decoding method, comprising the steps of:
receiving data that has been subjected to bit puncture processing, based on number of bits of data that can be transmitted within 1 frame;. and
decoding said data based on reliability information of the punctured bit of said data, as a low set value.

6. The data decoding method according to claim 5, wherein
in said step of decoding, a bit having reliability of 0 is inserted to said data.
